# EUROPEAN PATENT APPLICATION

(11) **EP 4 372 269 A1**
(43) Date of publication of application: **22.05.2024**
(21) Application number: 22207579.8
(22) Date of filing: 15.11.2022
(51) Int. Cl.: F21S 43/20, F21S 43/239, F21S 43/245, F21S 43/249, F21S 43/15, F21S 43/145, F21S 43/14, F21S 43/50, F21S 43/27, H10K 50/115, H01L 33/50

(54) **AUTOMOTIVE LUMINOUS DEVICE**

(71) Applicant: Valeo Vision, 93012 Bobigny Cedex (FR)
(72) Inventor: SANTAELLA HERNANDEZ, Juan Jose, 23600 MARTOS (ES)
(74) Representative: Valeo Visibility

(57) **Abstract**

The present invention refers to an automotive luminous device (10) comprising a light source (1), a diffusive mask (2) and a quantum dot layer. The diffusive mask (2) comprises a plurality of diffusive portions (3) and at least one opaque portion (4), wherein each diffusive portion is configured to diffuse or scatter light received from the light source (1) and project it outside the luminous device (10). The quantum dot layer contains quantum dots deposited on at least one of the diffusive portions (3).

## Description

### TECHNICAL FIELD

This invention belongs to the field of electronic assemblies comprised within the automotive luminous devices, intended to provide luminous functions to the vehicles.

### STATE OF THE ART

Automotive lighting market can be considered one of the most competitive ones and new lighting functionalities are constantly required.

In some cases, when different colours are to be output from a single lighting module, more than one different light source is to be provided.

This is the case, for example, of those lighting devices which provide lighting functions, and are aimed to project light in a specific pattern with opaque masks.

Opaque masks are used to define a specific pattern, such as a honeycomb, a matrix-like structure or even letters and words, which may be intended to be projected by any of the auxiliary functions such as welcome light, luggage light or any other function which projects defined figures.

These specific patterns are usually obtained by frames which receive a diffused light and divide it into different regions, which are projected outside the lighting device.

However, these frames usually absorb light, and the light projected is substantially dimmed compared to the light initially emitted by the light source.

The present invention provides a way of solving this problem.

### DESCRIPTION OF THE INVENTION

The invention provides an alternative solution for providing a patterned light in an automotive luminous device by an automotive luminous device comprising
a light source;
a diffusive mask comprising a plurality of diffusive portions and at least one opaque portion, wherein each diffusive portion is configured to diffuse or scatter light received from the light source and project it outside the luminous device; and
a quantum dot layer containing quantum dots deposited on at least one of the diffusive portions.

The diffusive portions are configured to diffuse or scatter the light received by them. This phenomenon is known by the skilled person. The novelty is depositing quantum dots on the diffusive portions and isolate two adjacent diffusive portions by opaque portions. With such an embodiment, a patterned light may be obtained without the need of frames, so that the diffusive portions are the only element which interposes between the light source and the user. Hence, light received outside the lighting device is much higher than in the case of the light frame.

A quantum dot is an electronic structure obtained out of a semiconductor nanocrystal, with a size such that their electrons and holes are confined in all three spatial dimensions. Depending on the particular sizes of the quantum dots, they emit light in a particular wavelength (bandgap) when they are excited, either electrically or luminescently. As a consequence, "red" quantum dots would be quantum dots which emit light in the red bandgap when excited, "green" quantum dots would be quantum dots which emit light in the green bandgap when excited, etc. However, when they are not excited, they may not be visible. This is because quantum dots are deposited in a nanometric layer using a thin film deposition technology. By controlling the amount and density of the quantum dots, this layer could be not visible when not excited either by an electric or by a luminescent stimulator.

These quantum dots are an advantageous solution since they provide flexibility in the design of the automotive lighting devices, allowing new ways of designing the different functionalities of a lighting device: lighting, indicating, signalling.

In some particular embodiments, the diffusive portions comprise processed polycarbonate or poly methyl methacrylate or a combination thereof.

These elements provide a good light diffusion, which causes a homogenization of the light emitted by the light source. This is obtained without a major light loss, as in the event of a frame.

In some particular embodiments, the opaque portion contains an opaque material deposited on the diffusive mask.

This opaque material may be any material which provides a luminous transparency which is substantially lower than the original of the diffusive element, or even a modification of the surface of the diffusive material in some zones, thus creating an opaque effect. Hence, a contrast is achieved between the diffusive portion and the opaque portion.

In other particular embodiments, the opaque portion is comprised on the diffusive mask.

This means that in some cases there are some portions of the same diffusive mask which are less transparent to light, so that they may work as dividers between diffusive portions. In other cases, a different opaque material may be inserted in the diffusive mask to create this effect. In other cases, when combined with electroluminescence quantum dots, the opaque portions are just portions of the diffusive mask which are not receiving quantum dots, so that they are not illuminated and they do not project any light, since they not receive any light.

In some particular embodiments, the automotive luminous device further comprises a light filter arranged on the diffusive mask.

Light filter provides a further customization in terms of light absorption and intensity.

In some particular embodiments, the diffusive mask has a thickness lower than 2 cm, measured in a direction perpendicular to the light crossing the diffusive mask.

The invention allows the installation of the device in a reduced space, since it only requires the emission light source and the diffuser.

In some particular embodiments, the distance between two diffusive portions is lower than 1 mm.

Since the opaque portions are as thin as necessary, the pattern may be obtained with any distance.

In some particular embodiments, the quantum dots are deposited on a substrate layer which is in turn deposited on the diffusive mask, and wherein the opaque portion is deposited on the substrate layer to partially cover the substrate layer.

In these cases, a single substrate with quantum dots is deposited on the diffusive mask, and some opaque material such as thin strips are installed over it, to cover part of the single substrate and thus create the opaque portion.

In other embodiments, the quantum dots are deposited on substrate portions, and each substrate portion is deposited on a diffusive portion.

Hence, in these cases, the opaque portions do not need to cover the quantum dots substrate, and it may be installed in free zones where the substrate portions are not installed.

In other embodiments, a plurality of quantum dots are deposited directly on each diffusive portion.

In these cases, the quantum dots are directly installed on the diffusive material, and there is no need of an additional substrate to carry them.

In some particular embodiments, the automotive luminous device comprises an auxiliary optical element configured to receive the light emitted by the light source and project it towards the diffusive mask.

In these cases, the light emitted by the light source does not reach the diffusive mask directly, but by the interposition of an auxiliary optical element, which is configured to receive light in one direction and project it in a different direction. These cases are advantageous when the space for the light sources is small and a lateral arrangement is recommended.

These auxiliary optical elements, such as lightguides or reflectors, are specially adapted for this purpose.

In some particular embodiments, the light source is a solid-state light source configured to emit light in a blue, deep blue or ultraviolet wavelength, wherein the solid-state light sources are arranged to emit light towards the diffusive mask.

The term "solid state" refers to light emitted by solid-state electroluminescence, which uses semiconductors to convert electricity into light. Compared to incandescent lighting, solid state lighting creates visible light with reduced heat generation and less energy dissipation. The typically small mass of a solid-state electronic lighting device provides for greater resistance to shock and vibration compared to brittle glass tubes/bulbs and long, thin filament wires. They also eliminate filament evaporation, potentially increasing the lifespan of the illumination device. Some examples of these types of lighting comprise semiconductor light-emitting diodes (LEDs), organic light-emitting diodes (OLED), or polymer light-emitting diodes (PLED) as sources of illumination rather than electrical filaments, plasma or gas.

With this arrangement, light is emitted in a first wavelength, instead of a mixture of different wavelengths such as a white light. Blue is a common option, but other wavelengths such as deep blue or even ultraviolet could also be used without any issue. Even if this light is diffracted, due to the fact that the source light is emitted in a single wavelength, the resulting beam pattern is not an uncontrolled mixture of different colours. The wavelength conversion layer modifies the wavelength of this resulting beam pattern so that it complies with the automotive regulations of the specific functionality. When blue light sources are used and a white light is required, red and green quantum dots are used, but depending on the wavelength of the light source and the desired final colour, different quantum dots will be used.

In some particular embodiments, the quantum dot layers are configured to be excited by photoluminescence.

In these cases, the quantum dot layers are configured to emit light when receiving the light by the solid-state light source. Then, light is emitted directly from the quantum dots which are deposited on the diffusive portions.

In some particular embodiments, the light sources are the quantum dot layers.

In some particular embodiments, the quantum dots are arranged either in an input surface or in an output surface of the diffusive portions.

The input surface is defined in the direction of the light, so is the surface of the diffusive mask which is closer to the light source. The output surface is defined as the surface which is further to the light source.

In other cases, there are no solid-state light sources, but the light sources are the quantum dots themselves, when excited by an electrical power source.

In some particular embodiments, the quantum dot layers are configured to be excited by electroluminescence, and each diffusive portion further comprises an anode layer, a hole injection layer, a hole transport layer, an electron transport layer and a cathode.

In these cases, a power source is connected to the quantum dots, so that when an electric signal is received, the quantum dots emit light.

In some particular embodiments, the quantum dot layers are arranged in an input surface of the diffusive portions.

In some particular embodiments, the quantum dot layers are configured to be excited independently.

In these cases, different colours or temporary animations may be obtained.

Unless otherwise defined, all terms (including technical and scientific terms) used herein are to be interpreted as is customary in the art. It will be further understood that terms in common usage should also be interpreted as is customary in the relevant art and not in an idealised or overly formal sense unless expressly so defined herein.

In this text, the term "comprises" and its derivations (such as "comprising", etc.) should not be understood in an excluding sense, that is, these terms should not be interpreted as excluding the possibility that what is described and defined may include further elements, steps, etc.

### BRIEF DESCRIPTION OF THE DRAWINGS

To complete the description and in order to provide for a better understanding of the invention, a set of drawings is provided. Said drawings form an integral part of the description and illustrate an embodiment of the invention, which should not be interpreted as restricting the scope of the invention, but just as an example of how the invention can be carried out. The drawings comprise the following figures:
Figure 1 shows a first embodiment of an automotive luminous device according to the invention.
Figure 2 shows a second embodiment of an automotive luminous device according to the invention.
Figure 3 shows a further embodiment of an automotive luminous device according to the invention.
Figure 4 shows a detailed view of the diffusive portions of the embodiment of Figure 3.

In these figures, the following reference numbers have been used:
- 1: LED
- 2: Diffusive element
- 3: Diffusive portion
- 4: Opaque portion
- 5: PCB
- 6: Clamps
- 7: Lightguide
- 8: Reflection direction
- 10: Automotive lighting device
- 11: Anode layer
- 12: Hole injection layer
- 13: Hole transport layer
- 14: Quantum dot layer
- 15: Electron transport layer
- 16: Cathode layer

### DETAILED DESCRIPTION OF THE INVENTION

The example embodiments are described in sufficient detail to enable those of ordinary skill in the art to embody and implement the systems and processes herein described. It is important to understand that embodiments can be provided in many alternate forms and should not be construed as limited to the examples set forth herein.

Accordingly, while embodiment can be modified in various ways and take on various alternative forms, specific embodiments thereof are shown in the drawings and described in detail below as examples. There is no intent to limit to the particular forms disclosed. On the contrary, all modifications, equivalents, and alternatives falling within the scope of the appended claims should be included. Elements of the example embodiments are consistently denoted by the same reference numerals throughout the drawings and detailed description where appropriate.

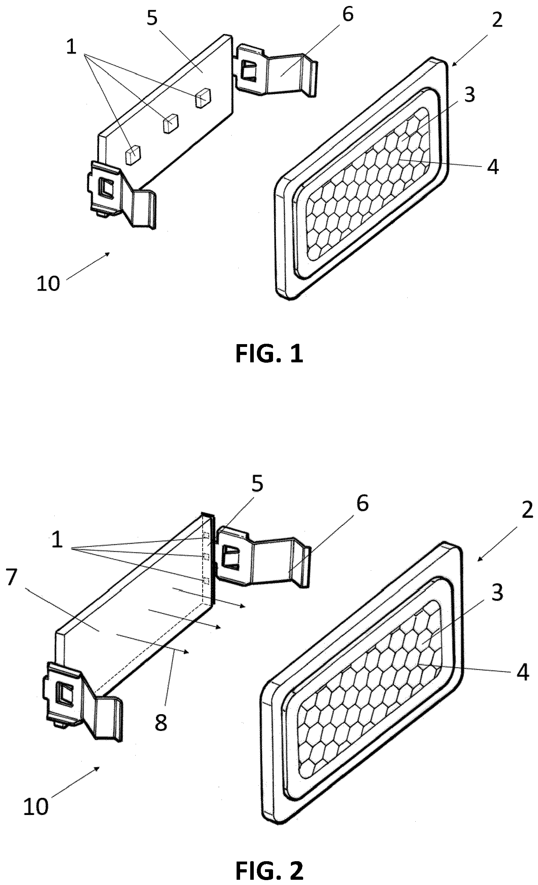

Figure 1 shows an exploded view of a first embodiment of an automotive luminous device 10 according to the invention.

In this figure, three LEDs 1 contained in a printed circuit board 5 and a diffusive mask 2 are seen. The diffusive mask 2 is a light diffuser which comprises some opaque portions 4 so that light is only projected through some diffusive portions 3. The diffusive mask 2 contains processed polycarbonate or poly methyl methacrylate or a combination thereof, so that light emitted from the LEDs 1 is scattered and then projected through the diffusive portions 3 in a soft manner. The diffusive mask 2 is intended to be clamped by some clamps 6 which are attached to the printed circuit board 5. In this case there are three LEDs 1, but the invention may be carried out with any convenient number of LEDs 1, depending on the particular application and dimensions of the diffusive mask 2.

In this embodiment, a plurality of quantum dots are deposited on the output surface of the diffusive mask 2. Since the three LEDs 1 are blue LEDs, blue light emitted by the LEDs 1 is scattered in the diffusive portions 3 and then crosses the quantum dots installed in the diffusive portions 3, so that the colour of the light changes, and then is projected outside the luminous device.

Adjacent diffusive portions are separated by thin opaque strips 4. They are deposited on the diffusive mask 2 after the quantum dots, so that the light is scattered and projected by the diffusive portions 3 that are formed between the opaque strips 4. These opaque strips are as thin as 1 mm, to create a honeycomb effect.

In this case, the quantum dots are deposited on the diffusive material and then some opaque strips are installed over them. However, in different embodiments, the effect of diffusive portions and opaque portions may be obtained by other means: for example, by installing a substrate of quantum dots instead of the quantum dots themselves, or by etching some boundaries of the diffusive portions, or by modifying the surface of the diffusive material to create opaque portions.

With this lighting device, a light pattern, such as a honeycomb, is achieved, but without using a frame. Further, other complex light patterns may also be obtained with this invention.

The whole device is very thin, since the element which is thicker is the diffusive mask 2, and it is only 1 cm thick.

Figure 2 shows an exploded view of a second embodiment of an automotive luminous device 10 according to the invention.

In this case, the printed circuit board 5 is much smaller than in the previous case, and is located perpendicularly to a main optic lightguide 7, so that the LEDs 1, which are located on the printed circuit board 5 emit light towards the interior of the optic lightguide 7, and the light, after being internally reflected by the optic lightguide 7, is sent towards the diffusive mask 2 according to a reflection direction 8.

Once the light is reflected by the lightguide 7, the operation of this lighting device is the same as in the embodiment of Figure 1.

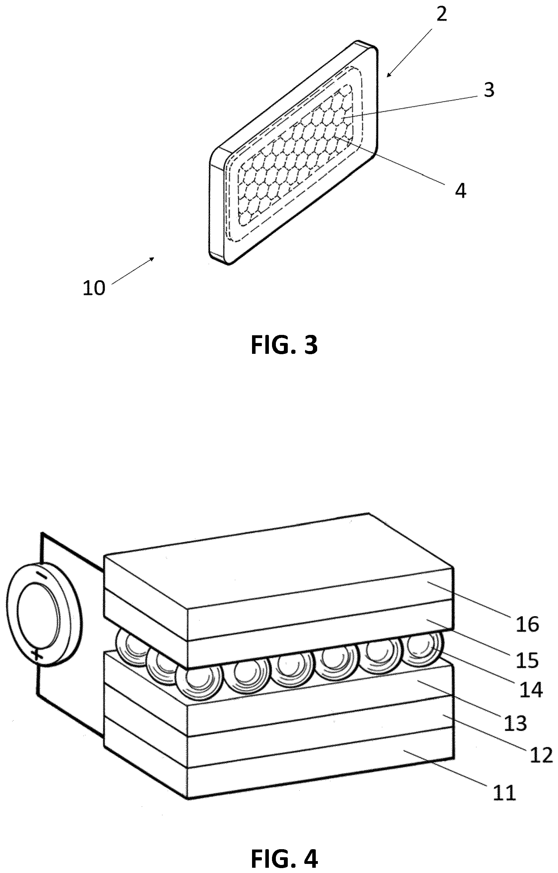

Figure 3 shows an exploded view of a further embodiment of an automotive luminous device 10 according to the invention.

In this case, there are no LEDs, since the light will be emitted by the quantum dots, which are configured to be excited by electroluminescence. To achieve this, each diffusive portion 3 contains a substrate portion with quantum dots, installed in the inner surface of the diffusive material. Each substrate portion is individually fed by an electric connection, so that, when each substrate portion is excited, light is emitted by the quantum dots contained herein and light is scattered through the diffusive material and projected outside the lighting device. Since each diffusive portion is individually fed, each diffusive portion 3 may be activated independently, to create an animation effect if required.

The opaque portions 4 are formed by surface modifications on the surface of the diffusive material.

With this lighting device, a light pattern, such as a honeycomb, is achieved, but without using a frame. Further, other complex light patterns may also be obtained with this invention.

The whole device is very thin, since the element which is thicker is the diffusive mask 2, and it is only 1 cm thick.

The automotive luminous device further comprises a light filter arranged on the diffusive mask.

Figure 4 shows a detailed view of the diffusive portions of the embodiment of Figure 3.

In this case, since the quantum dots are excited by electroluminescence, the diffusive portions 3 comprise a plurality of layers: an anode layer 11, a hole injection layer 12, a hole transport layer 13, a quantum dot layer 14, an electron transport layer 15 and a cathode 16. A voltage is induced between the anode 11 and the cathode 16, so that electrons are injected and then recombined in the quantum dots and photons are emitted.

## Claims

1. Automotive luminous device comprising
a light source (1);
a diffusive mask (2) comprising a plurality of diffusive portions (3) and at least one opaque portion (4), wherein each diffusive portion is configured to diffuse or scatter light received from the light source (1) and project it outside the luminous device (10); and
a quantum dot layer containing quantum dots deposited on at least one of the diffusive portions (3).

2. Automotive luminous device according to claim 1, wherein the diffusive portions (3) comprise processed polycarbonate or poly methyl methacrylate or a combination thereof.

3. Automotive luminous device according to any of the preceding claims, wherein the opaque portion (4) contains an opaque material deposited on the diffusive mask (2).

4. Automotive luminous device according to claims 1 or 2, wherein the opaque portion (4) is comprised on the diffusive mask (2).

5. Automotive luminous device according to any of the preceding claims, further comprising a light filter arranged on the diffusive mask (2).

6. Automotive luminous device according to any of the preceding claims, wherein the diffusive mask (2) has a thickness lower than 2 cm, measured in a direction perpendicular to the light crossing the diffusive mask, and the distance between two diffusive portions (3) is lower than 1 mm.

7. Automotive luminous device according to any of the preceding claims, further comprising an auxiliary optical element (7) configured to receive the light emitted by the light source and project it towards the diffusive mask (2) according to a projection direction (8).

8. Automotive luminous arrangement according to any of the preceding claims, wherein the quantum dots are deposited on a substrate layer which is in turn deposited on the diffusive mask (2), and wherein the opaque portion is deposited on the substrate layer to partially cover the substrate layer.

9. Automotive luminous device according to any of claims 1 to 7, wherein the quantum dots are deposited on substrate portions, and each substrate portion is deposited on a diffusive portion (3).

10. Automotive luminous device according to any of claims 1 to 7, wherein a plurality of quantum dots are deposited directly on each diffusive portion (3).

11. Automotive luminous device according to any of the preceding claims, wherein the light source is a solid-state light source configured to emit light in a blue, deep blue or ultraviolet wavelength, wherein the solid-state light sources are arranged to emit light towards the diffusive mask, wherein the quantum dot layers are configured to be excited by photoluminescence.

12. Automotive luminous device according to claim 11, wherein the quantum dots are arranged either in an input surface or in an output surface of the diffusive portions.

13. Automotive luminous device according to any of claims 1 to 10, wherein the light sources are the quantum dot layers and the quantum dot layers are configured to be excited by electroluminescence and each diffusive portion further comprises an anode layer, a hole injection layer, a hole transport layer, an electron transport layer and a cathode.

14. Automotive luminous device according to claim 13, wherein the quantum dot layers are arranged in an input surface of the diffusive portions.

15. Automotive luminous device according to any of claims 13 or 14, wherein the quantum dot layers are configured to be excited independently.
